# EUROPÄISCHE PATENTSCHRIFT

(11) **EP 0 727 110 B1**
(45) Veröffentlichungstag und Bekanntmachung des Hinweises auf die Patenterteilung: **16.07.1997**
(21) Anmeldenummer: 95929750.8
(22) Anmeldetag: 05.09.1995
(51) Int. Cl.: H03K 3/57

(54) **ANORDNUNG ZUR ERZEUGUNG EINER HOCHFREQUENTEN NADELPULSFOLGE UND EINER DAZU INVERTIERTEN NADELPULSFOLGE**
ARRANGEMENT FOR GENERATING A HIGH-FREQUENCY SPIKE PULSE TRAIN AND A CORRESPONDING REVERSED SPIKE PULSE TRAIN
DISPOSITIF DE GENERATION D'UNE SUITE D'IMPULSIONS EN POINTE DE HAUTE FREQUENCE ET D'UNE SUITE CORRESPONDANTE D'IMPULSIONS EN POINTE INVERSEES

(30) Priorität: 07.09.1994 DE 4431885
(43) Veröffentlichungstag der Anmeldung: 21.08.1996
(73) Patentinhaber: SIEMENS AKTIENGESELLSCHAFT, 80333 München (DE)
(72) Erfinder: HEIDE, Patric, D-81371 München (DE); SCHWARTE, Rudolf, D-57250 Netphen (DE)
(86) Internationale Anmeldenummer: DE9501198
(87) Internationale Veröffentlichungsnummer: WO9608081

(56) Entgegenhaltungen:
- EP-A- 0 238 745
- FR-A- 1 447 443
- US-A- 3 173 020
- US-A- 3 997 843
- INTERNATIONALE ELEKTRONISCHE RUNDSCHAU, Bd. 24, Nr. 7, Juli 1970 BERLIN DE, Seiten 178-180, PFEIFFER 'Erzeugung von Rechteckimpulsen mit Avalanche-Transistoren'
- JOURNAL OF PHYSICS E SCIENTIFIC INSTRUMENTS., Bd. 17, Nr. 3, März 1984 BRISTOL GB, Seiten 204-207, GEORGI ET AL. 'A 5 kV nanosecond-risetime pulse generator gating an electro-optical shutter'

## Beschreibung

Zur oszillographischen Darstellung elektrischer Signale mit sehr schnellen Anstiegszeiten im Pico- oder Subpicobereich werden üblicherweise Sampling-Oszilloskope verwendet. Durch zeitversetzte Abtastung eines repetierenden, periodischen Signals wird dessen Signalform in einem, um eine Größenordnung langsameren Zeitmaßstab rekonstruiert. Die Abtastung geschieht mit Sampling-Toren, die von hochfrequenten Nadelimpulsen durchgeschaltet werden. Aus Symmetriegründen wird dazu vielfach eine Nadelimpulsfolge sowie eine dazu invertierte exakt symmetrische Nadelimpulsfolge benötigt.

Die Aufgabe der Erfindung ist es, eine Anordnung zur Erzeugung einer hochfrequenten Nadelimpulsfolge und einer dazu invertierten Nadelimpulsfolge anzugeben.

Die Erfindung wird gemäß den Patentansprüchen 1 oder 4 gelöst.

Vorteilhafte Weiterbildungen der Erfindung ergeben sich aus den abhängigen Ansprüchen.

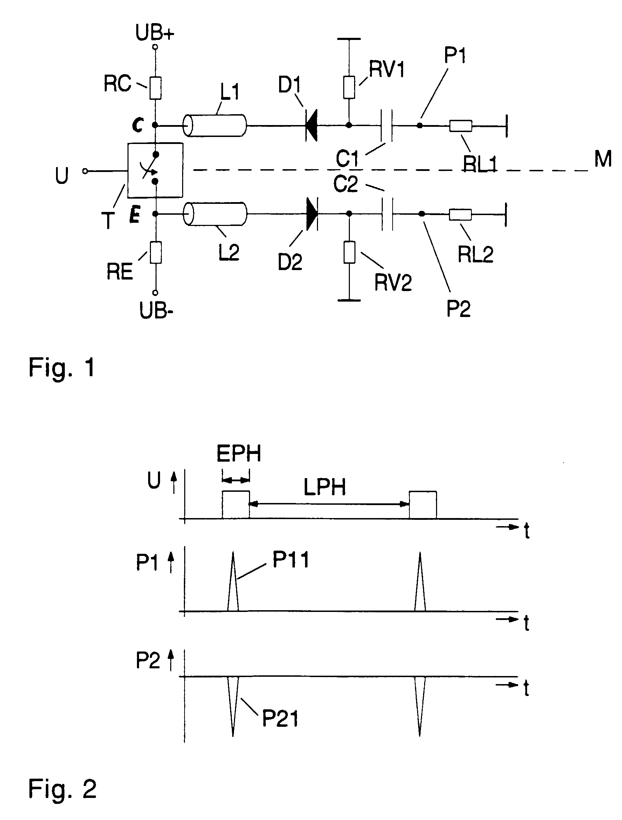

Anhand der Figuren 1 und 2 soll die Erfindung näher erläutert werden.

Es zeigt
- Figur 1: eine mögliche Ausführungsform der erfindungsgemäßen Anordnung und
- Figur 2: ein zu der in der Figur 1 gezeigten Anordnung gehöriges Zeitdiagramm.

Bei der in Figur 1 gezeigten Anordnung zur Erzeugung der Nadelimpulsfolgen P₁ und P₂ ist während der in Figur 2 angegebenen Ladephase LPH der Schalter T gesperrt. Über den Widerstand RC bzw. RE lädt sich der Leiter L₁ bzw. L₂ auf die Betriebspannung U_{B+} bzw. U_{B-} auf. Die Diode D₁ ist aufgrund der niederfrequenzmaßig wirksamen Beschaltung mit den Widerständen RC und RV₁ während der Ladephase LPH gesperrt. Die Diode D₂ ist aufgrund der niederfrequenzmaßig wirksamen Beschaltung mit den Widerständen RE und RV₂ während der Ladephase LPH ebenfalls gesperrt. Daher wirkt die Diode D₁ oder D₂ an dem, dem Schalter T entgegengesetzten Ende des Leiters L₁ bzw. L₂ hochfrequenzmäßig als Leerlauf.

Während der Entladephase EPH wird der Schalter T, vom Taktsignal U gesteuert, kurzgeschlossen das heißt niederohmig.

Die während der Ladephase LPH in dem Leiter L₁ gespeicherte Energie fließt während der Entladephase EPH in Form eines kurzen positiven Nadelimpulses P₁₁ über den kurzgeschlossenen Schalter T in Richtung des Leiters L₂ ab und schaltet während der Dauer des Nadelimpulses P11 die Diode D₂ leitend. Hochfrequenzmaßig wirkt der Kondensator C₂ als Kurzschluß, so daß der Nadelimpuls P₁₁ an dem Lastwiderstand RL₂ abgreifbar ist. Gleichzeitig fließt entsprechend die während der Ladephase LPH in dem Leiter L₂ gespeicherte Energie während der Entladephase EPH in Form eines kurzen negativen Nadelimpulses P21 über den kurzgeschlossenen Schalter T in Richtung des Leiters L₁ ab und schaltet während der Dauer dieses Nadelimpulses P₂₁ die Diode D₁ leitend. Auch hier wirkt hochfrequenzmäßig der Kondensator C₁ als Kurzschluß, so daß der Nadelimpuls P₂₁ an dem Lastwiderstand RL₁ abgreifbar ist.

Durch die Ansteuerung des Schalters T mit einem periodisch wiederholten Signal U, wie in Figur 2 angegeben, wiederholen sich die geschilderten Vorgänge entsprechend periodisch.

Die angegebene Schaltung ist bezüglich einer Mittellinie M symmetrisch aufgebaut. Vorteil dieser Symmetrie ist, daß auch die erzeugten Nadelimpulse symmetrisch sind.

Für die korrekte Funktion der Schaltung ist es erforderlich, daß die Leiter L₁ und L₂ identisch aufgebaute unsymmetrische Leitungen sind, z.B. Koaxialkabel oder Mikrostreifenleitung. Alternativ kann anstatt zwei unsymmetrischen Leitungen auch nur eine symmetrische Leitung verwendet werden, beispielsweise können die Leiter L₁ und L₂ die beiden Leiter einer symmetrischen Zweidrahtleitung oder einer Koplanarleitung sein. Die Vorteile der Verwendung einer symmetrischen Leitung sind eine erzielbare, bessere Symmetrie der Nadelimpulse und ein geringerer Schaltungsaufwand.

Die Längen der Leiter L₁ und L₂ sind identisch zu wählen und bestimmen die Dauer der Nadelimpulse. Die Spannungen U_{B+} und U_{B-} sind, von ihrem Vorzeichen abgesehen, identisch zu wählen und bestimmen die Amplitude der Nadelimpulse.

Für eine korrekte Funktion der Schaltung ist es weiterhin erforderlich, daß die Wellenwiderstände der Leiter L₁ und L₂ und der Lastwiderstände RL₁ und RL₂ identisch sind. Werden als Leiter statt zwei unsymmetrischen Leitungen eine symmetrische Leitung verwendet, so sind die Lastwiderstände identisch dem halben Wellenwiderstand der symmetrischen Leitung zu wählen.

Die Funktion des Schalters T kann ein Transistor erfüllen.

Die Funktion der Widerstände RC, RE, RV₁ und RV₂ kann auch durch Spulen erfüllt werden.

Die angegebene Anordnung kann zur Ansteuerung einer Signalabtasteinheit verwendet werden.

## Patentansprüche

1. Anordnung zur Erzeugung einer hochfrequenten Nadelpulsfolge und einer dazu invertierten Nadelpulsfolge,
- bei der ein von einem Taktsignal (U) steuerbarer Schalter (T) vorgesehen ist,
dessen erster Ausgang (C) sowohl mit einem Ende eines ersten Leiters (L₁) der Länge L als auch einem Widerstand R_{C}, an dem eine positive Betriebsspannung (U_{B+}) anliegt, verbunden ist,
dessen zweiter Ausgang (E) sowohl mit einem Ende eines zweiten mit dem ersten Leiter (L₁) identischen Leiters (L₂) der Länge L als auch einem Widerstand R_{E}, an dem eine negative Betriebsspannung (U_{B-}) anliegt, verbunden ist,
- bei der das andere Ende des ersten Leiters (L₁) mit einem Anschluß einer ersten Diode (D₁) verbunden ist,
- bei der das andere Ende des zweiten Leiters (L₂) mit einem Anschluß einer zweiten Diode (D₂) mit gegenüber der ersten Diode (D₁) entgegengesetzter Polung verbunden ist,
- bei der der andere Anschluß der ersten Diode (D₁) mit einem nach Masse geschalteten Widerstand RV₁ und einem Anschluß eines ersten Kondensators (C₁) verbunden ist,
- bei der der andere Anschluß der zweiten Diode (D₂) mit einem nach Masse geschalteten Widerstand RV₂ und einem Anschluß eines zweiten Kondensators (C₂) verbunden ist,
- bei der der andere Anschluß des ersten Kondensators (C₁) mit einem Widerstand RL₁, der nach Masse geschaltet ist und über den die Nadelpulsfolge (P₁) abgreifbar ist, verbunden ist, und
- bei der der andere Anschluß des zweiten Kondensators (C₂) mit einem Widerstand RL₂, der nach Masse geschaltet ist und über den die invertierte Nadelpulsfolge (P₂) abgreifbar ist, verbunden ist.

2. Anordnung nach Anspruch 1,
bei der der steuerbare Schalter (T) ein Transistor ist.

3. Anordnung nach Anspruch 1 oder 2,
bei der über die Länge L der Leiter (L₁, L₂) die Nadelpulsbreite einstellbar ist.

4. Anordnung nach einem der Ansprüche 1 - 3,
bei der einer oder mehrere der Widerstände R_{C}, R_{E}, RV₁, RV₂ durch eine oder mehrere Spulen ersetzt sind.

5. Anordnung nach einem der Ansprüche 1 - 4,
bei der der erste Leiter (L₁) und der zweite Leiter (L₂) jeweils eine unsymmetrische Leitung sind.

6. Anordnung nach Anspruch 5,
bei der die unsymmetrische Leitung ein Koaxialkabel oder eine Mikrostreifenleitung ist.

7. Anordnung nach einem der Ansprüche 1 - 4,
bei der der erste Leiter (L₁) und der zweite Leiter (L₂) zusammen eine symmetrische Leitung bilden.

8. Anordnung nach Anspruch 7,
bei der die symmetrische Leitung zwei Streifenleiter, eine Zweidrahtleitung oder eine Koplanarleitung aufweist.

9. Anordnung nach einem der Ansprüche 1 - 3, 5-8,
bei der jeweils der erste und der zweite Leiter (L₁, L₂), die erste und die zweite Diode (D₁, D₂), die Widerstände RV₁ und RV₂, der erste und der zweite Kondensator (C₁, C₂) und die Widerstände RL₁ und RL₂ elektrisch gleichwirkend sind.

10. Verwendung der Anordnung nach einem der Ansprüche 1 - 9,
zur Signalabtastung bei periodischen Vorgängen.

## Claims

1. Arrangement for the generation of a high-frequency needle pulse train and of a needle pulse train which is inverted with respect thereto,
- in which a switch (T) which can be controlled by a clock signal (U) is provided,
the first output (C) of which switch is connected both to one end of a first conductor (L₁) having the length L and to a resistor R_{C} to which a positive operating voltage (U_{B+}) is applied,
the second output (E) of which switch is connected both to one end of a second conductor (L₂), which is identical to the first conductor (L₁) and has the length L, and to a resistor R_{E} to which a negative operating voltage (U_{B-}) is applied,
- in which the other end of the first conductor (L₁) is connected to a terminal of a first diode (D₁),
- in which the other end of the second conductor (L₂) is connected to a terminal of a second diode (D₂) which is biased oppositely to the first diode (D₁),
- in which the other terminal of the first diode (D₁) is connected to a resistor RV₁, which is connected to earth, and to a terminal of a first capacitor (C₁),
- in which the other terminal of the second diode (D₂) is connected to a resistor RV₂, which is connected to earth, and to a terminal of a second capacitor (C₂),
- in which the other terminal of the first capacitor (C₁) is connected to a resistor RL₁, which is connected to earth and via which the needle pulse train (P₁) can be picked off, and
- in which the other terminal of the second capacitor (C₂) is connected to a resistor RL₂, which is connected to earth and via which the inverted needle pulse train (P₂) can be picked off.

2. Arrangement according to claim 1,
in which the controllable switch (T) is a transistor.

3. Arrangement according to Claim 1 or 2,
in which the needle pulse width can be set via the length L of the conductors (L₁, L₂).

4. Arrangement according to one of Claims 1 - 3,
in which one or more of the resistors R_{C}, R_{E}, RV₁, RV₂ are replaced by one or more coils.

5. Arrangement according to one of Claims 1 - 4,
in which the first conductor (L₁) and the second conductor (L₂) are in each case an asymmetrical line.

6. Arrangement according to Claim 5,
in which the asymmetrical line is a coaxial cable or a microstrip line.

7. Arrangement according to one of Claims 1 - 4,
in which the first conductor (L₁) and the second conductor (L₂) together form a symmetrical line.

8. Arrangement according to Claim 7,
in which the symmetrical line has two striplines, one two-wire line or one coplanar line.

9. Arrangement according to one of Claims 1 - 3, 5 - 8,
in which in each case the first and the second conductor (L₁, L₂), the first and the second diode (D₁, D₂), the resistors RV₁ and RV₂, the first and the second capacitor (C₁, C₂) and the resistors RL₁ and RL₂ have the same electrical effect.

10. Use of the arrangement according to one of Claims 1 - 9 for signal sampling in periodic events.

## Revendications

1. Dispositif de génération d'une suite d'impulsions en pointe de haute fréquence et d'une suite correspondante d'impulsions en pointe inversées,
- dans lequel on prévoit un commutateur (T) pouvant être commandé par un signal de synchronisation (U),
- dont la première sortie ( C ) est reliée à la fois à une extrémité d'un premier conducteur (L₁) de longueur L et à une résistance R_{C} à laquelle est appliquée une tension de service positive (U_{B+}),
- dont la seconde sortie (E) est reliée à la fois à une extrémité d'un second conducteur (L₂) de longueur L identique au premier conducteur (L₁) et à une résistance R_{E} à laquelle est appliquée une tension de service négative (U_{B-}),
- dans lequel l'autre extrémité du premier conducteur (L₁) est reliée à une connexion d'une première diode (D₁),
- dans lequel l'autre extrémité du second conducteur (L₂) est reliée à une connexion d'une seconde diode (D₂) ayant une polarité contraire à la première diode (D₁),
- dans lequel l'autre connexion de la première diode (D₁) est reliée à une résistance RV₁ branchée à la terre et à une connexion d'un premier condensateur (C₁),
- dans lequel l'autre connexion de la seconde diode (D₂) est reliée à une résistance RV₂ branchée à la terre et à une connexion d'un second condensateur (C₂),
- dans lequel l'autre connexion du premier condensateur (C₁) est reliée à une résistance RL₁ qui est branchée à la terre et au moyen de laquelle la suite d'impulsions en pointe (P₁) peut être mesurée, et
- dans lequel l'autre connexion du second condensateur (C₂) est reliée à une résistance RL₂ qui est branchée à la terre et au moyen de laquelle la suite d'impulsions en pointe inversées (P₂) peut être mesurée.

2. Dispositif selon la revendication 1, dans lequel le commutateur (T) pouvant être commandé est un transistor.

3. Dispositif selon la revendication 1 ou 2, dans lequel la largeur des impulsions en pointe peut être réglée par le biais de la longueur L des conducteurs (L₁, L₂).

4. Dispositif selon l'une des revendications 1 à 3, dans lequel une ou plusieurs des résistances R_{C}, R_{E}, RV₁, RV₂ est/sont remplacée/s par une ou plusieurs bobine/s.

5. Dispositif selon l'une des revendications 1 à 4, dans lequel le premier conducteur (L₁) et le second conducteur (L₂) sont formés, à chaque fois, par une ligne non symétrique.

6. Dispositif selon la revendication 5, dans lequel la ligne non symétrique est un câble coaxial ou une microbande.

7. Dispositif selon l'une des revendications 1 à 4, dans lequel le premier conducteur (L₁) et le second conducteur (L₂) forment, ensemble, une ligne symétrique.

8. Dispositif selon la revendication 7, dans lequel la ligne symétrique comprend deux microbandes, une ligne à deux fils ou une ligne coplanaire.

9. Dispositif selon l'une des revendications 1 à 3, 5 à 8, dans lequel les premier et second conducteurs (L₁, L₂), les première et seconde diodes (D₁, D₂), les résistances RV₁ et RV₂, les premier et second condensateurs (C₁, C₂) et les résistances RL₁ et RL₂ sont, à chaque fois, équivalents sur le plan électrique.

10. Utilisation du dispositif selon l'une des revendications 1 à 9 pour le balayage de signaux lors de processus périodiques.
